(19) Europäisches Patentamt / European Patent Office / Office européen des brevets

(11) **EP 3 478 045 B1**

(12) **EUROPEAN PATENT SPECIFICATION**

(45) Date of publication and mention
of the grant of the patent:
**19.10.2022 Bulletin 2022/42**

(21) Application number: **17819723.2**

(22) Date of filing: **24.05.2017**

(51) International Patent Classification (IPC):
*H05K 7/20* (2006.01)    *H01L 23/36* (2006.01)
*H01L 23/373* (2006.01)    *H01L 23/42* (2006.01)

(52) Cooperative Patent Classification (CPC):
**H01L 23/373; H01L 23/3737; H01L 23/42;
H05K 7/20**

(86) International application number:
**PCT/JP2017/019334**

(87) International publication number:
**WO 2018/003356 (04.01.2018 Gazette 2018/01)**

(54) **HEAT DISSIPATING DEVICE**

WÄRMEABLEITUNGSVORRICHTUNG

DISPOSITIF DE DISSIPATION DE CHALEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.06.2016   JP 2016128122**

(43) Date of publication of application:
**01.05.2019 Bulletin 2019/18**

(73) Proprietor: **Zeon Corporation**
**Tokyo 100-8246 (JP)**

(72) Inventors:
• **KOBAYASHI, Gen**
**Tokyo 100-8246 (JP)**
• **MURAKAMI, Yasuyuki**
**Tokyo 100-8246 (JP)**
• **UCHIUMI, Daisuke**
**Tokyo 100-8246 (JP)**

(74) Representative: **Vos, Derk**
**Maiwald Patentanwalts- und
Rechtsanwaltsgesellschaft mbH
Elisenhof
Elisenstraße 3
80335 München (DE)**

(56) References cited:
**EP-A1- 2 546 871    JP-A- H01 117 049
JP-A- 2004 140 275    JP-A- 2005 229 100
JP-A- 2010 132 856    JP-A- 2011 204 749
JP-A- 2015 185 562    JP-A- 2016 178 235
US-A1- 2003 227 959    US-A1- 2004 125 565
US-A1- 2005 145 367    US-A1- 2010 302 739
US-A1- 2012 236 502    US-A1- 2014 374 897
US-A1- 2015 206 822    US-A1- 2015 315 451
US-A1- 2016 106 004**

**Description**

TECHNICAL FIELD

The present disclosure relates to a heat radiation device, and particularly to a heat radiation device including a heat generator, a heat radiator, and a heat conductive sheet.

BACKGROUND

In recent years, electronic elements included in semiconductor packages, power modules, integrated circuits (IC, LSI), plasma display panels (PDP), and the like constituting electronic devices generate more heat along with their increasing performance. Examples of such electronic elements include semiconductor elements such as transistors including insulated-gate bipolar transistors (IGBT) and field-effect transistors (FET) and diodes including light-emitting diodes (LED).

To prevent functional failures of electronic devices caused by temperature rises in their electronic elements, for example, heat radiation from an electronic element needs to be enhanced to favorably release heat generated from the electronic element to the outside.

A method typically used to enhance heat radiation from an electronic element involves attaching a heat radiator such as a heat sink made of metal to an electronic element or a heat generator such as a power module including the electronic element to facilitate heat radiation. When using the heat radiator, for efficient transfer of heat from the heat generator to the heat radiator, the heat generator and the heat radiator are closely attached to each other via a sheet member having heat conductivity (heat conductive sheet) to form a heat radiation device, thus facilitating heat radiation.

To favorably radiate heat from the heat radiation device, typically the heat conductivity of the heat conductive sheet sandwiched between the heat generator and the heat radiator needs to be high and the heat resistance between the heat generator and the heat radiator needs to be low. Thus, efficient heat transfer from the heat generator to the heat radiator is required.

For example, JP 2008-153430 A (PTL 1) focuses on fine irregularities of a surface of a heat radiation member, and discloses use of a heat conductive sheet including a heat conductive fine filler having a particle diameter of less than or equal to 1/10 of the fine irregularities, an inorganic filler having a predetermined particle diameter, and a thermosetting resin. According to PTL 1, high heat conductivity is achieved as a result of the fine irregularities of the surface of the heat radiation member being filled with the heat conductive fine filler in the heat conductive sheet.

US2015315451 A1 refers to a carbon nanotube sheet including a plurality of carbon nanotubes and a resin portion filled between the plurality of carbon nanotubes. Each of the plurality of carbon nanotubes is bent at a first constriction portion to a lateral direction in the resin portion.

EP2546871 A1 refers to a heat dissipating structure comprising a heat source and a heat dissipating part disposed opposite to each other, a concave portion formed on at least either of the mutually opposed surfaces of the heat source and the heat dissipating part, and a thermal conducting component comprising a filler layer of thermoplastic material that is disposed between the heat source and the heat dissipating part and is in contact with the mutually opposed surfaces of the heat source and the heat dissipating part.

According to US2012236502 A1 a sheet-shaped structure includes a bundle structure that includes a plurality of line-shaped structures of carbon atoms, a covering layer that covers the line-shaped structures in longitudinal directions of the line-shaped structures, respectively, and a filling layer that is disposed between the line-shaped structures covered with the covering layer.

JP2010132856 refers to a heat conductive sheet for use in heat radiators. The heat conductive sheet comprises a composition containing graphite particles whose scaly surface direction, or major axis direction of ellipse or rod is oriented in the thickness direction of the sheet.

CITATION LIST

Patent Literature

PTL 1: JP 2008-153430 A

SUMMARY

(Technical Problem)

However, conventional heat radiation devices having a structure in which a heat conductive sheet is interposed between a heat generator and a heat radiator are required to further reduce the heat resistance between the heat generator and the heat radiator to radiate heat more favorably.

It could therefore be helpful to provide a heat radiation device that can achieve high heat radiation.

(Solution to Problem)

The inventors conducted extensive studies to achieve the stated object. The inventors attempted to reduce the heat resistance between the heat generator and the heat radiator by increasing the heat conductivity of the heat conductive sheet in the thickness direction. However, the inventors learned through research that increasing the heat conductivity of the heat conductive sheet in the thickness direction may not necessarily lead to sufficient reduction in the heat resistance between the heat generator and the heat radiator. The inventors conducted further studies, and discovered that, in a heat radiation device including a heat conductive sheet having at least predetermined heat conductivity between a heat generator and a heat radiator, the heat resistance between the heat generator and the heat radiator decreases more in the case where the heat conductive sheet with high heat conductivity is attached in a sandwiched manner in only part of the region where the heat generator and the heat radiator face each other than in the case where the heat conductive sheet with high heat conductivity is attached in a sandwiched manner in the whole region where the heat generator and the heat radiator face each other.

To advantageously solve the problems stated above, a presently disclosed heat radiation device comprises: a heat generator; a heat radiator; and a heat conductive sheet attached in a sandwiched manner between the heat generator and the heat radiator, wherein a heat conductivity of the heat conductive sheet in a thickness direction is 15 W/m·K or more, and an area of a sandwiched surface of the heat conductive sheet is smaller than an area of an attached surface of the heat generator and the heat radiator. By using the heat conductive sheet having predetermined heat conductivity and setting the area of the sandwiched surface of the heat conductive sheet to be smaller than the area of the attached surface of the heat generator and the heat radiator in this way, the heat resistance between the heat generator and the heat radiator can be reduced sufficiently, so that the heat radiation device can achieve high heat radiation.

In the present disclosure, "heat conductivity" can be measured by the method described in the EXAMPLES section of the present specification.

In the present disclosure, "sandwiched surface of the heat conductive sheet" denotes the surface (contact portion) in contact with the heat generator or the heat radiator from among the surfaces of the heat conductive sheet included in the heat radiation device. In the case where the area of the surface of the heat conductive sheet in contact with the heat generator and the area of the surface of the heat conductive sheet in contact with the heat radiator are different, "area of the sandwiched surface" denotes the smaller area of the two areas. In the case where a plurality of heat conductive sheets are arranged in a plane between the heat generator and the heat radiator, "area of the sandwiched surface" denotes the total area of the sandwiched surfaces of all heat conductive sheets.

In the present disclosure, "attached surface of the heat generator and the heat radiator" denotes the facing surface of the heat generator or the heat radiator in the range (i.e. the maximum range in which the heat generator and the heat radiator can be in close contact with each other via the heat conductive sheet regardless of whether or not the heat conductive sheet is actually interposed therebetween) in which the heat generator and the heat radiator face each other, in the whole surface (whole facing surface) on the side where the heat generator and the heat radiator face each other.

In the present disclosure, "area" of each surface is calculated from the outside dimensions (e.g. outer diameter) of the surface without taking into account the below-described surface irregularity.

Preferably, in the presently disclosed heat radiation device, an Asker C hardness of the heat conductive sheet at 25 °C is 30 or more. If the hardness of the heat conductive sheet is not less than the foregoing lower limit, the heat conductive sheet can be provided with sufficient physical strength, and the heat resistance between the heat generator and the heat radiator can be further reduced to further enhance the heat radiation of the heat radiation device.

In the present disclosure, "Asker C hardness" (hereafter also simply referred to as "hardness") can be measured at a temperature of 25 °C using a hardness meter according to the Asker C method of the Society of Rubber Industry, Japan Standard (SRIS0101).

Preferably, in the presently disclosed heat radiation device, a thickness of the heat conductive sheet is 2.0 mm or less. If the thickness of the heat conductive sheet is not more than the foregoing upper limit, the heat resistance between the heat generator and the heat radiator can be further reduced to further enhance the heat radiation of the heat radiation device.

Preferably, in the presently disclosed heat radiation device, a proportion of the area of the sandwiched surface of the heat conductive sheet to the area of the attached surface of the heat generator and the heat radiator is 10 % or more and 70 % or less. If the proportion of the area of the sandwiched surface of the heat conductive sheet is not less than the foregoing lower limit, a sufficient size of the heat conductive sheet in contact with the heat generator and the heat radiator can be ensured, thus enabling the heat radiation device to achieve high heat radiation. If the proportion of the area of the sandwiched surface of the heat conductive sheet is not more than the foregoing upper limit, the heat resistance between the heat generator and the heat radiator can be further reduced to further enhance the heat radiation of the heat radiation device.

Preferably, in the presently disclosed heat radiation device, an attached surface of at least one of the heat generator and the heat radiator has a surface irregularity of more than 5 $\mu$m. If the surface irregularity of the attached surface of the heat generator and/or the heat radiator is more than the foregoing lower limit, the heat resistance reduction effect when setting the area of the sandwiched surface of the heat conductive sheet having predetermined heat conductivity to be smaller than the area of the attached surface is significant.

In the present disclosure, "surface irregularity" can be measured by the following method.

First, a horizontal spread with respect to a center point located at an approximate center on a measured surface is set as a reference plane. The center point can be set visually. For example, in the case where the measured surface is a polygon, the point approximately equidistant from each vertex or the intersection point of the diagonal lines can be the center point. In the case where the measured surface is a circle, the center of the circle or the intersection point of the major axis and the minor axis can be the center point. Next, a graph representing the surface irregularity shape state in the thickness direction on a predetermined line at the measured surface is obtained using a laser microscope such as a three-dimensional shape measuring machine. Herein, "on a predetermined line" denotes on a straight line passing through the highest point and the lowest point in the thickness direction in the plane of the measured surface. The larger absolute value of the height difference between the height of the reference plane and the maximum height (maximum value) and the height difference between the height of the reference plane and the minimum height (minimum value) in the thickness direction in the obtained graph is taken to be "surface irregularity".

Herein, a surface whose surface irregularity is 5 $\mu$m or less is regarded as "smooth".

Preferably, in the presently disclosed heat radiation device, the heat conductive sheet contains a resin and a carbon material. If the heat conductive sheet contains these components, the heat conductive sheet in the heat radiation device can easily exert higher heat conductivity. This further enhances the heat radiation of the heat radiation device.

Preferably, in the presently disclosed heat radiation device, the resin is a thermoplastic resin. If the heat conductive sheet contains a thermoplastic resin, while maintaining high heat conductivity of the heat conductive sheet in the heat radiation device, its flexibility for being sandwiched between the heat generator and the heat radiator can be improved. This enhances the heat radiation of the heat radiation device more efficiently.

(Advantageous Effect)

It is therefore possible to provide a heat radiation device that can achieve high heat radiation.

DETAILED DESCRIPTION

One of the disclosed embodiments is described in detail below.

A presently disclosed heat radiation device can be used, for example, as an electronic member including an electronic element in an electronic device in which the electronic element is provided. The presently disclosed heat radiation device may be completely incorporated inside any type of device such as the electronic device, or part or all of the presently disclosed heat radiation device may be installed outside the device such as the electronic device.

The presently disclosed heat radiation device can be produced by assembling the below-described heat generator, heat radiator, and predetermined heat conductive sheet under predetermined conditions according to any method.

Examples of devices in which the presently disclosed heat radiation device can be suitably used include, but are not limited to, an electronic device such as a server, a personal computer for a server, or a desktop computer; a portable electronic device such as a notebook computer, an electronic dictionary, a PDA, a mobile phone, or a portable music player; a display device such as a liquid crystal display (including a backlight), a plasma display, a liquid crystal projector, or a watch; an inkjet printer (ink head); an image forming device such as an electrophotographic device (a developing device, a fixing device, a heat roller, a heat belt); a vacuum treatment device; a semiconductor manufacturing device; a manufacturing device such as a display manufacturing device; an insulating device including a heat insulating material, a vacuum heat insulating material, a radiation heat insulating material, or the like; a data recording device such as a DVD (optical pickup, laser generator , laser light receiver) or a hard disk drive; an image recording device such as a camera, a video camera, a digital camera, a digital video camera, a microscope, or a CCD; and a battery device such as a charging device, a lithium-ion battery, or a fuel cell.

(Heat radiation device)

The presently disclosed heat radiation device includes a heat generator, a heat radiator, and a heat conductive sheet having predetermined heat conductivity, wherein the heat conductive sheet is attached in a sandwiched manner between the heat generator and the heat radiator under the condition that the area of the sandwiched surface of the heat conductive sheet is smaller than the area of the attached surface of the heat generator and the heat radiator. The presently disclosed heat radiation device may optionally include other members such as fixing components for fixing the structural members to each other, in addition to the heat generator, the heat radiator, and the heat conductive sheet.

In the presently disclosed heat radiation device, the heat conductive sheet having predetermined heat conductivity is sandwiched between the heat generator and the heat radiator under the predetermined area condition, so that the heat resistance between the heat generator and the heat radiator is low and the heat radiation as a heat radiation device is high. Thus, the presently disclosed heat radiation device can, for example, efficiently radiate heat generated from an electronic element or a heat generator such as a power module including an electronic element to the outside. This prevents, for example, a functional failure caused by heat from a heat generator, in a device such as an electronic device including the presently disclosed heat radiation device.

<Heat generator>

The heat generator is a structural member included in the presently disclosed heat radiation device, and sandwiches the heat conductive sheet with the below-described heat radiator in the presently disclosed heat radiation device. In other words, the heat generator is an attached body that is attached to the heat conductive sheet in the presently disclosed heat radiation device.

[Type]

The heat generator is not limited, as long as it generates heat in any type of device such as an electronic device. Examples of the type of the heat generator include semiconductor devices such as transistors, diodes, thyristors, organic EL, and inorganic EL; semiconductor-related parts such as integrated circuits (IC, LSI) and IC chips, e.g. memories or central processing units (CPU) including such semiconductor devices, semiconductor packages, semiconductor sealing cases, semiconductor die bonding, power modules, power transistors, and power transistors cases; and wiring boards (including printed wiring boards, etc.) such as rigid wiring boards, flexible wiring boards, ceramic wiring boards, build-up wiring boards, and multilayer boards.

Examples of the transistors include field-effect transistors (FET), metal oxide semiconductor field-effect transistors (MOSFET), and insulated gate bipolar transistors (IGBT).

Examples of the diodes include light-emitting diodes (LED) and photodiodes.

Of these, the heat generator attached to the heat conductive sheet in the presently disclosed heat radiation device is preferably an IC chip including a semiconductor device, a power module, or the like, in terms of handleability.

[Attached surface]

The heat generator has an attached surface facing the below-described heat radiator. Typically, heat generated from the heat generator is mostly transferred to the heat radiator via the attached surface and radiated.

[[Surface irregularity]]

The surface irregularity of the attached surface of the heat generator is preferably more than 5 $\mu$m, more preferably 15 $\mu$m or more, and further preferably 25 $\mu$m or more, and is preferably 50 $\mu$m or less and more preferably 35 $\mu$m or less. If the surface irregularity of the attached surface of the heat generator is more than the foregoing lower limit, the effect of reducing the heat resistance between the heat generator and the heat radiator can be further enhanced, and the heat radiation of the heat radiation device can be enhanced more efficiently. If the surface irregularity of the attached surface of the heat generator is not more than the foregoing upper limit, excessively high strain in the surface portion of the heat generator in contact with the heat conductive sheet can be prevented, and the close adherence between the heat generator and the heat conductive sheet can be maintained favorably. Consequently, the heat resistance between the heat generator and the heat radiator can be further reduced, and the heat radiation of the heat radiation device can be enhanced more efficiently.

<Heat radiator>

The heat radiator is a structural member included in the presently disclosed heat radiation device, and sandwiches the heat conductive sheet with the above-described heat generator in the presently disclosed heat radiation device. In other words, the heat radiator is an attached body that is attached to the heat conductive sheet in the presently disclosed heat radiation device.

[Type]

Examples of the type of the heat radiator include heat sinks having shaped portions such as plates or fins; blocks connected to heat pipes; blocks having a structure of circulating a cooling liquid by a pump; Peltier devices; heat sinks including Peltier devices; and blocks including Peltier devices. The heat sinks and the blocks are typically made of metal such as aluminum or copper, in terms of favorable heat radiation.
Of these, the heat radiator that is in contact with the heat conductive sheet in the presently disclosed heat radiation device is preferably a heat sink made of metal such as aluminum or copper, in terms of handleability and heat radiation.

[Attached surface]

The heat radiator has an attached surface facing the above-described heat generator. Typically, heat generated from the heat generator is mostly transferred to the heat radiator via the attached surface and radiated.

[[Surface irregularity]]

The surface irregularity of the attached surface of the heat radiator is preferably 50 $\mu$m or less, more preferably 35 $\mu$m or less, and further preferably 10 $\mu$m or less, without being limited thereto. If the surface irregularity of the attached surface of the heat radiator is not more than the foregoing upper limit, excessively high strain in the surface portion of the heat radiator in contact with the heat conductive sheet can be prevented, and the close adherence between the heat radiator and the heat conductive sheet can be maintained favorably. Consequently, the heat resistance between the heat generator and the heat radiator can be further reduced, and the heat radiation of the heat radiation device can be enhanced more efficiently.
It is more preferable that at least the attached surface of the heat generator has the foregoing surface irregularity. It is further preferable that the attached surfaces of the heat generator and the heat radiator each have the foregoing surface irregularity. If at least the surface irregularity of the attached surface of the heat generator is more than the foregoing lower limit, the effect of reducing the heat resistance between the heat generator and the heat radiator can be further enhanced and the heat radiation of the heat radiation device can be enhanced more efficiently when the heat conductive sheet is sandwiched between the heat generator and the heat radiator under the below-described predetermined area condition. If at least the surface irregularity of the attached surface of the heat generator is not more than the foregoing upper limit, excessively high strain in the surface portion of each of the heat generator and the heat radiator in contact with the heat conductive sheet can be prevented, and the close adherence between each of the heat generator and the heat radiator and the heat conductive sheet can be maintained favorably. Consequently, the heat resistance between the heat generator and the heat radiator can be further reduced, and the heat radiation of the heat radiation device can be enhanced more efficiently.

<Heat conductive sheet>

The heat conductive sheet has predetermined heat conductivity, and is sandwiched between the heat generator and the heat radiator under the condition that the area of the sandwiched surface of the heat conductive sheet is smaller than the area of the attached surface of the heat generator and the heat radiator in the presently disclosed heat radiation device. In the case where the heat conductive sheet does not have the predetermined heat conductivity or in the case where the heat conductive sheet is not sandwiched between the heat generator and the heat radiator under the foregoing predetermined area condition, the heat radiation device cannot exert high heat radiation.
A heat conductive sheet typically has higher heat conductivity than air, and thus improves heat transfer between a heat generator and a heat radiator via the heat conductive sheet and facilitates heat radiation from the heat generator to the heat radiator. Accordingly, in normal cases the heat resistance between the heat generator and the heat radiator can be reduced more when the heat conductive sheet is favorably in close contact with a larger region of the attached surface of the heat generator and the heat radiator, i.e. when the region in which the heat conductive sheet is not present between the attached surfaces of the heat generator and the heat radiator is smaller. However, the surfaces of the heat generator and the heat radiator generally have irregularity not visually recognizable. In view of this, it is presumed that, in the case where the heat conductive sheet has at least predetermined heat conductivity as in the present disclosure, the close adherence between the heat conductive sheet and the heat generator and/or the heat radiator is enhanced to achieve more efficient heat transfer when the heat conductive sheet is attached in a sandwiched manner in only part of the region where the heat generator and the heat radiator face each other rather than when the heat conductive sheet is attached in a sandwiched manner in the whole region where the heat generator and the heat radiator face each other.

[Properties]

[[Heat conductivity]]

The heat conductivity of the heat conductive sheet in the thickness direction at 50 °C needs to be 15 W/m·K or more. The heat conductivity of the heat conductive sheet in the thickness direction at 50 °C is preferably 20 W/m·K or more, and more preferably 25 W/m·K or more. If the heat conductivity is not less than the foregoing lower limit, the heat resistance between the heat generator and the heat radiator can be reduced efficiently in the case where the area of the sandwiched surface of the heat conductive sheet is set to be smaller than the area of the attached surface of the heat generator and the heat radiator and the heat conductive sheet is sandwiched between the heat generator and the heat radiator. This enables the heat radiation device to exert high heat radiation.

[[Hardness]]

The Asker C hardness of the heat conductive sheet at 25 °C is preferably 30 or more, more preferably 40 or more, further preferably 50 or more, and still more preferably 60 or more, and is preferably 90 or less and more preferably 80 or less. If the hardness of the heat conductive sheet is not less than the foregoing lower limit, the heat conductive sheet can be provided with sufficient physical strength, and the heat resistance between the heat generator and the heat radiator can be reduced more efficiently to further enhance the heat radiation of the heat radiation device. If the hardness of the heat conductive sheet is not more than the foregoing upper limit, favorable close adherence between the heat generator and the heat radiator via the heat conductive sheet can be ensured without the heat conductive sheet being excessively hard. A heat radiation device with high heat radiation can thus be obtained.

[[Thickness]]

The thickness of the heat conductive sheet is preferably 2.0 mm or less, more preferably 1.5 mm or less, further preferably 0.6 mm or less, and still more preferably 0.4 mm or less, and is preferably 0.25 mm or more. If the thickness of the heat conductive sheet is not more than the foregoing upper limit, the heat resistance (hereafter also referred to as "bulk heat resistance") of the heat conductive sheet itself can be reduced to thus enhance the heat radiation of the heat radiation device. In addition, as a result of enhancing the flexibility of the heat conductive sheet and improving the shape followability of the heat conductive sheet to the attached surfaces of the heat generator and the heat radiator, the heat radiation of the heat radiation device can be further enhanced. If the thickness of the heat conductive sheet is not less than the foregoing lower limit, high heat conductivity of the heat conductive sheet can be maintained without the thickness of the heat conductive sheet being excessively thin, and thus favorable heat radiation of the heat radiation device can be ensured. Moreover, handleability when, for example, installing the heat conductive sheet can be improved.

[Composition]

The heat conductive sheet preferably contains a resin and a carbon material. If the heat conductive sheet contains a resin and a carbon material, a heat conductive sheet having high heat conductivity can be obtained easily, so that a heat radiation device capable of exerting high heat radiation can be produced easily.

[[Resin]]

Any resin can be used and any of the resins known in the art which may be used for forming a heat conductive sheet can be used. Specific examples of usable resins are a thermoplastic resin and a thermosetting resin. A thermoplastic resin and a thermosetting resin may be used in combination.
In the present disclosure, "resin" encompasses rubbers and elastomers.

- Thermoplastic resin -

Of these, the resin is preferably a thermoplastic resin, and more preferably a thermoplastic fluororesin. By using a thermoplastic resin, for example in a high-temperature environment during use of the heat radiation device (during heat radiation), the flexibility of the heat conductive sheet can be improved and the close adherence between the heat generator and the heat radiator via the heat conductive sheet can be improved. Consequently, the heat resistance between the heat generator and the heat radiator can be further reduced to improve the heat radiation of the heat radiation device. The use of a thermoplastic fluororesin also improves the heat resistance, oil resistance, and chemical resistance of the heat conductive sheet, in addition to the foregoing effects.

The thermoplastic resin may contain a thermoplastic resin that is solid at 23 °C and 1 atm and a thermoplastic resin that is liquid at 23 °C and 1 atm. In the case of using a thermoplastic resin that is solid at normal temperature and normal pressure and a thermoplastic resin that is liquid at normal temperature and normal pressure, in a normal temperature and normal pressure environment such as during installation or replacement, the solid thermoplastic resin component and the liquid thermoplastic resin component coexist in the heat conductive sheet. This improves the balance between hardness and flexibility of the heat conductive sheet, and contributes to higher handleability. Moreover, in a high-temperature environment during use of the heat radiation device (during heat radiation), the thermoplastic resin that is solid at normal temperature and normal pressure is plasticized, thus improving close adherence between each of the heat generator and the heat radiator and the heat conductive sheet. Consequently, the heat resistance between the heat generator and the heat radiator can be reduced further efficiently to improve the heat radiation of the heat radiation device more efficiently.

In the present disclosure, "normal temperature" refers to 23 °C, and "normal pressure" refers to 1 atm (absolute pressure).

= Thermoplastic resin that is solid at normal temperature and normal pressure =

Examples of the thermoplastic resin that is solid at 23 °C and 1 atm include acrylic resins such as poly(2-ethylhexyl acrylate), copolymers of acrylic acid and 2-ethylhexyl acrylate, polymethacrylic acids or esters thereof, and polyacrylic acids or esters thereof; silicone resins; fluororesins; polyethylenes; polypropylenes; ethylene-propylene copolymers; polymethylpentenes; polyvinyl chlorides; polyvinylidene chlorides; polyvinyl acetates; ethylene-vinyl acetate copolymers; polyvinyl alcohols; polyacetals; polyethylene terephthalates; polybutylene terephthalates; polyethylene naphthalates; polystyrenes; polyacrylonitriles; styrene-acrylonitrile copolymers; acrylonitrile-butadiene-styrene copolymers (ABS resins); styrene-butadiene block copolymers or hydrogenated products thereof; styrene-isoprene block copolymers or hydrogenated products thereof; polyphenylene ethers; modified polyphenylene ethers; aliphatic polyamides; aromatic polyamides; polyamideimides; polycarbonates; polyphenylene sulfides; polysulfones; polyether sulfones; polyether nitriles; polyether ketones; polyketones; polyurethanes; liquid crystal polymers; and ionomers. These thermoplastic resins may be used alone or in combination.

Of these, the thermoplastic resin that is solid at normal temperature and normal pressure is preferably a thermoplastic fluororesin that is solid at normal temperature and normal pressure.

Examples of the thermoplastic fluororesin that is solid at normal temperature and normal pressure include elastomers obtained by polymerizing fluorine-containing monomers, such as vinylidene fluoride-based fluororesins, tetrafluoroethylene-propylene-based fluororesins, and tetrafluoroethylene-perfluoro vinyl ether-based fluororesins. More specific examples include polytetrafluoroethylene, tetrafluoroethylene-perfluoroalkyl vinyl ether copolymers, tetrafluoroethylene-hexafluoropropylene copolymers, tetrafluoroethylene-ethylene copolymers, polyvinylidene fluoride, polychloro trifluoroethylene, ethylene-chloro fluoroethylene copolymers, tetrafluoroethylene-perfluorodioxole copolymers, polyvinyl fluoride, tetrafluoroethylene-propylene copolymers, vinylidene fluoride-tetrafluoroethylene-hexafluoropropylene copolymers, acrylic-modified products of polytetrafluoroethylene, ester-modified products of polytetrafluoroethylene, epoxy-modified products of polytetrafluoroethylene, and silane-modified products of polytetrafluoroethylene. Of these, polytetrafluoroethylene, acrylic modified products of polytetrafluoroethylene, tetrafluoroethylene-perfluoroalkyl vinyl ether copolymers, and vinylidene fluoride-tetrafluoroethylene-hexafluoropropylene copolymers are preferable in terms of processability.

Examples of commercially available products of the thermoplastic fluororesin that is solid at normal temperature and normal pressure include DAI-EL® (DAI-EL is a registered trademark in Japan, other countries, or both) G-700 series (polyol vulcanizing and binary polymer, vinylidene fluoride-based fluororesin) and DAI-EL G-550 series/G-600 series (polyol vulcanizing and terpolymer, vinylidene fluoride-based fluororesin) produced by Daikin Industries, Ltd.; and KYNAR® (KYNAR is a registered trademark in Japan, other countries, or both) series (vinylidene fluoride-based fluororesin) and KYNAR FLEX® (KYNAR FLEX is a registered trademark in Japan, other countries, or both) series (ternary fluororesin of vinylidene fluoride/tetrafluoroethylene/hexafluoropropylene copolymer) produced by Alkema Inc.

= Thermoplastic resin that is liquid at normal temperature and normal pressure =

Examples of the thermoplastic resin that is liquid at normal temperature and normal pressure include acrylic resins, epoxy resins, silicone resins, and fluorine resins. These may be used alone or in combination.

Of these, the thermoplastic resin that is liquid at normal temperature and normal pressure is preferably a thermoplastic fluororesin that is liquid at normal temperature and normal pressure.

The thermoplastic fluororesin that is liquid at normal temperature and normal pressure is not limited as long as it is a thermoplastic fluororesin in liquid state at normal temperature and normal pressure. Examples of the thermoplastic fluororesin that is liquid at normal temperature and normal pressure include vinylidene fluoride/hexafluoropropylene copolymers, vinylidene fluoride-hexafluoropentene-tetrafluoroethylene terpolymers, perfluoropropene oxide polymers, and tetrafluoroethylene-propylene-vinylidene fluoride copolymers.

Examples of commercially available products of the thermoplastic fluororesin in liquid state at normal temperature and normal pressure include Viton® (Viton is a registered trademark in Japan, other countries, or both) LM (produced by DuPont), DAI-EL® (DAI-EL is a registered trademark in Japan, other countries, or both) G101 (produced by Daikin Industries, Ltd.), Dyneon FC2210 (produced by 3M Co., Ltd.), and SIFEL series (produced by Shin-Etsu Chemical Co., Ltd.).

The viscosity of the thermoplastic fluororesin that is liquid at normal temperature and normal pressure is not limited, yet the viscosity at a temperature of 105 °C is preferably 500 cps or more and 30000 cps or less and more preferably 550 cps or more and 25000 cps or less, in terms of achieving favorable kneadability, fluidity, and crosslinking reactivity and excellent formability.

= Blending proportion in thermoplastic resin =

The blending proportions of the thermoplastic resin that is solid at normal temperature and normal pressure and the thermoplastic resin that is liquid at normal temperature and normal pressure when used in combination as the thermoplastic resin are not limited. Preferably, the blending proportion of the thermoplastic resin that is solid at normal temperature and normal pressure is 80 mass% or less and 30 mass% or more and the blending proportion of the thermoplastic resin that is liquid at normal temperature and normal pressure is 20 mass% or more and 70 mass% or less with respect to 100 mass% of the thermoplastic resin.

Regarding the blending proportions of the thermoplastic fluororesin that is solid at normal temperature and normal pressure and the thermoplastic fluororesin that is liquid at normal temperature and normal pressure when used in combination as the thermoplastic resin, it is preferable that the blending proportion of the thermoplastic fluororesin that is solid at normal temperature and normal pressure is 80 mass% or less and 30 mass% or more and the blending proportion of the thermoplastic fluororesin that is liquid at normal temperature is 20 mass% or more and 70 mass% or less with respect to 100 mass% of the thermoplastic resin. It is more preferable that the blending proportion of the thermoplastic fluororesin that is solid at normal temperature and normal pressure is 65 mass% or less and 40 mass% or more and the blending proportion of the thermoplastic fluororesin that is liquid at normal temperature and normal pressure is 35 mass% or more and 60 mass% or less with respect to 100 mass% of the thermoplastic resin.

If the blending proportions of the thermoplastic resin that is solid at normal temperature and normal pressure and the thermoplastic resin that is liquid at normal temperature and normal pressure are in the foregoing ranges, in a normal temperature and normal pressure environment such as during installation or replacement, the balance between hardness and flexibility of the heat conductive sheet can be improved, which contributes to higher handleability. Moreover, in a high-temperature environment during use of the heat radiation device (during heat radiation), the close adherence between each of the heat generator and the heat radiator and the heat conductive sheet can be enhanced. Consequently, the heat resistance between the heat generator and the heat radiator can be reduced further efficiently to improve the heat radiation of the heat radiation device more efficiently.

- Thermosetting resin -

Examples of the thermosetting resin include natural rubbers; butadiene rubbers; isoprene rubbers; nitrile rubbers; hydrogenated nitrile rubbers; chloroprene rubbers; ethylene propylene rubbers; chlorinated polyethylenes; chlorosulfonated polyethylenes; butyl rubbers; halogenated butyl rubbers; polyisobutylene rubbers; epoxy resins; polyimide resins; bismaleimide resins; benzocyclobutene resins; phenol resins; unsaturated polyesters; diallyl phthalate resins; polyimide silicone resins; polyurethanes; thermosetting polyphenylene ethers; and thermosetting modified polyphenylene ethers. These thermosetting resins may be used alone or in combination.

[[Carbon material]]

As carbon material, a particulate carbon material and a fibrous carbon material are used in combination. This results in an enhanced heat conductivity of the heat conductive sheet.

- Particulate carbon material -

The particulate carbon material used is expanded graphite for its capability of enhancing the heat conductivity of the heat conductive sheet.

= Expanded graphite =

Expanded graphite which may be suitably used as the particulate carbon material can be obtained, for example, by thermal expansion of expandable graphite which has been obtained by chemical treatment of graphite such as flake graphite with sulfuric acid or the like, followed by micronization. Examples of expanded graphite include EC1500, EC1000, EC500, EC300, EC100, and EC50 (all product names) produced by Ito Graphite Co., Ltd.

= Properties of particulate carbon material =

The average particle diameter of the particulate carbon material contained in the heat conductive sheet is preferably 0.1 $\mu$m or more, more preferably 1 $\mu$m or more, and further preferably 200 $\mu$m or more, and is preferably 250 $\mu$m or less. If the average particle diameter of the particulate carbon material is not less than the foregoing lower limit, the heat conductivity of the heat conductive sheet can be further enhanced. If the average particle diameter of the particulate carbon material is in the foregoing range, the heat conductive sheet having high heat conductivity can be obtained easily.

The average particle diameter of the particulate carbon material may be adjusted by changing the average particle diameter of the particulate carbon material used as raw material, or adjusted by changing the heat conductive sheet production conditions (e.g. the crushing conditions of the composition used in sheet formation, the pressing conditions in sheet formation).

The aspect ratio (major axis/minor axis) of the particulate carbon material contained in the heat conductive sheet is preferably 1 or more and 10 or less, and more preferably 1 or more and 5 or less.

In the present disclosure, "average particle diameter" can be found by measuring maximum diameters (major diameters) for randomly-selected 50 particulate carbon materials observed in a section of the heat conductive sheet in the thickness direction by a scanning electron micrograph (SEM) and calculating the number average of the measured major diameters. In the present disclosure, "aspect ratio" can be found by measuring maximum diameters (major diameters) and particle diameters in a direction orthogonal to the maximum diameter (minor diameters) for randomly-selected 50 particulate carbon materials observed in a section of the heat conductive sheet in the thickness direction by a scanning electron micrograph (SEM) and calculating the average of ratios of the major diameter to the minor diameter (major diameter/minor diameter).

= Content proportion of particulate carbon material =

The content proportion of the particulate carbon material contained in the heat conductive sheet is preferably 30 mass% or more and more preferably 40 mass% or more, and is preferably 90 mass% or less, more preferably 70 mass% or less, and further preferably 60 mass% or less, with respect to 100 mass% of the whole composition of the heat conductive sheet. If the content proportion of the particulate carbon material in the heat conductive sheet is not less than the foregoing lower limit, the heat conductive sheet having high heat conductivity can be obtained more easily. If the content proportion of the particulate carbon material in the heat conductive sheet is not more than the foregoing upper limit, the heat conductive sheet can be provided with more adequate flexibility for favorable close adherence to the heat generator and the heat radiator, and also dusting of the particulate carbon material can be prevented sufficiently.

- Fibrous carbon material -

The fibrous carbon material is not limited. Examples of usable fibrous carbon materials include carbon nanotubes, vapor grown carbon fibers, carbon fibers obtained by carbonization of organic fibers, and chopped products thereof. These fibrous carbon materials may be used alone or in combination.

If the heat conductive sheet contains the fibrous carbon material, the heat conductivity of the heat conductive sheet can be further improved, and also dusting of the particulate carbon material can be prevented. The reason why blending the fibrous carbon material prevents dusting of the particulate carbon material is not clear, but it is presumed that the fibrous carbon material forms a three-dimensional network structure which prevents detachment of the particulate carbon material while increasing the heat conductivity and strength of the heat conductive sheet.

Of these fibrous carbon materials, preferred are fibrous carbon nanostructures such as carbon nanotubes, with fibrous carbon nanostructures including carbon nanotubes being more preferred. The use of fibrous carbon nanostructures such as carbon nanotubes further improves the heat conductivity of the heat conductive sheet, and improves the strength.

= Fibrous carbon nanostructures including carbon nanotubes =

The fibrous carbon nanostructures including carbon nanotubes, which may be suitably used as the fibrous carbon material, may be composed solely of carbon nanotubes (hereinafter also referred to as "CNTs") or may be a mixture of CNTs and fibrous carbon nanostructures other than CNTs.

Any type of CNTs may be used in the fibrous carbon nanostructures, such as, for example, single-walled carbon nanotubes and/or multi-walled carbon nanotubes, with single- to up to 5-walled carbon nanotubes being preferred, and single-walled carbon nanotubes being more preferred. The use of single-walled carbon nanotubes allows for further improvement in the heat conductivity and strength of the heat conductive sheet as compared with those containing multi-walled carbon nanotubes.

The fibrous carbon nanostructures including CNTs are preferably carbon nanostructures having a ratio ($3\sigma$/Av) of a standard deviation ($\sigma$) of diameters multiplied by 3 ($3\sigma$) to average diameter (Av) of more than 0.20 and less than 0.60, more preferably carbon nanostructures having $3\sigma$/Av of more than 0.25, and further preferably carbon nanostructures having $3\sigma$/Av of more than 0.50. The use of fibrous carbon nanostructures including CNTs having $3\sigma$/Av of more than 0.20 and less than 0.60 allows for sufficient increases in the heat conductivity and strength of the heat conductive sheet even when only small amounts of carbon nanostructures have been blended. Thus, blending the fibrous carbon nanostructures including CNTs can suppress a significant decrease in the flexibility of the heat conductive sheet, so that sufficiently high levels of heat conductivity and flexibility of the heat conductive sheet can both be achieved.

Herein, "average diameter (Av) of fibrous carbon nanostructures" and "standard deviation ($\sigma$) (where $\sigma$ is sample standard deviation) of diameters of fibrous carbon nanostructures" can each be obtained by measuring the diameters (outer diameters) of 100 fibrous carbon nanostructures randomly-selected by a transmission electron microscope. The average diameter (Av) and standard deviation ($\sigma$) of the fibrous carbon nanostructures including carbon nanotubes may be adjusted either by changing the production method and/or the production conditions of the fibrous carbon nanostructures including carbon nanotubes or by combining a plurality of types of fibrous carbon nanostructures including CNTs, prepared by different production methods.

The fibrous carbon nanostructures including CNTs that are used typically take a normal distribution when a plot is made of diameter measured as described above on the horizontal axis and the frequency on the vertical axis, and Gaussian approximation is made.

Furthermore, the fibrous carbon nanostructures including CNTs preferably exhibit a radial breathing mode (RBM) peak when evaluated by Raman spectroscopy. Note that no RBM appears in the Raman spectrum of fibrous carbon nanostructures composed solely of multi-walled carbon nanotubes having three or more walls.

In a Raman spectrum of the fibrous carbon nanostructures including CNTs, the ratio of G band peak intensity to D band peak intensity (G/D ratio) is preferably 1.0 or more and 20 or less. A G/D ratio of 1.0 or more and 20 or less allows for sufficient increases in the heat conductivity and strength of the heat conductive sheet even when small amounts of fibrous carbon nanostructures have been blended. Thus, blending the fibrous carbon nanostructures including CNTs can suppress a significant decrease in the flexibility of the heat conductive sheet, so that sufficiently high levels of heat conductivity and flexibility of the heat conductive sheet can both be achieved.

The average diameter (Av) of the fibrous carbon nanostructures including CNTs is preferably 0.5 nm or more and further preferably 1 nm or more, and is preferably 15 nm or less and further preferably 10 nm or less. An average diameter (Av) of the fibrous carbon nanostructures of 0.5 nm or more can limit aggregation of fibrous carbon nanostructures to increase the dispersibility of the carbon nanostructures. An average diameter (Av) of the fibrous carbon nanostructures of 15 nm or less can sufficiently increase the heat conductivity and strength of the heat conductive sheet.

The fibrous carbon nanostructures including CNTs preferably have an average length of structures at the time of synthesis of 100 $\mu$m or more and 5000 $\mu$m or less. Fibrous carbon nanostructures having a longer structure length at the time of synthesis are more susceptible to damage to CNTs by breaking, severing, or the like during dispersion. Therefore, the average length of the structures at the time of synthesis is preferably 5,000 $\mu$m or less.

The BET specific surface area of the fibrous carbon nanostructures including CNTs is preferably 600 $m^2$/g or more and more preferably 800 $m^2$/g or more, and is preferably 2500 $m^2$/g or less and more preferably 1200 $m^2$/g or less. If the BET specific surface area of the fibrous carbon nanostructures including CNTs is 600 $m^2$/g or more, the heat conductivity and strength of the heat conductive sheet can be enhanced sufficiently. If the BET specific surface area of the fibrous carbon nanostructures including CNTs is 2500 $m^2$/g or less, aggregation of the fibrous carbon nanostructures can be suppressed to increase the dispersibility of CNTs in the heat conductive sheet.

As used herein, "BET specific surface area" refers to a nitrogen adsorption specific surface area measured by the BET method.

In accordance with the super growth method described later, the fibrous carbon nanostructures including CNTs are obtained, on a substrate having thereon a catalyst layer for carbon nanotube growth, in the form of an aggregate wherein fibrous carbon nanostructures are aligned substantially perpendicularly to the substrate (aligned aggregate). The mass density of the fibrous carbon nanostructures in the form of such an aggregate is preferably 0.002 $g/cm^3$ or

more and 0.2 g/cm$^3$ or less. A mass density of 0.2 g/cm$^3$ or less allows the fibrous carbon nanostructures to be homogeneously dispersed in the heat conductive sheet because binding among the fibrous carbon nanostructures is weakened. A mass density of 0.002 g/cm$^3$ or more improves the unity of the fibrous carbon nanostructures, thus preventing the fibrous carbon nanostructures from becoming unbound and making the fibrous carbon nanostructures easier to handle.

The fibrous carbon nanostructures including CNTs having the above-described properties can be efficiently produced, for example, according to the method (super growth method, see WO2006/011655) wherein during synthesis of CNTs through chemical vapor deposition (CVD) by supplying a feedstock compound and a carrier gas onto a substrate having thereon a catalyst layer for carbon nanotube production, the catalytic activity of the catalyst layer is dramatically improved by providing a trace amount of an oxidizing agent (catalyst activating material) in the system. Hereinafter, carbon nanotubes obtained by the super growth method are also referred to as "SGCNTs."

The fibrous carbon nanostructures including CNTs produced by the super growth method may be composed solely of SGCNTs, or may be composed of SGCNTs and other carbon nanostructures such as non-cylindrical carbon nanostructures.

= Properties of fibrous carbon material =

The average fiber diameter of the fibrous carbon material that can be contained in the heat conductive sheet is preferably 1 nm or more and more preferably 3 nm or more, and is preferably 2 $\mu$m or less and more preferably 1 $\mu$m or less. If the average fiber diameter of the fibrous carbon material is in the foregoing range, it is possible to allow the heat conductive sheet to have sufficiently high levels of heat conductivity, flexibility, and strength at the same time.

The aspect ratio of the fibrous carbon material preferably exceeds 10.

In the present disclosure, "average fiber diameter" can be found by measuring fiber diameters for 50 randomly-selected fibrous carbon materials observed in a section of the heat conductive sheet in the thickness direction by a scanning electron micrograph (SEM) or a transmission electron microscope (TEM) and calculating the number average of the measured fiber diameters. Particularly in the case of smaller fiber diameters, it is preferable to observe the same section by a transmission electron microscope (TEM).

= Content proportion of fibrous carbon material =

The content proportion of the fibrous carbon material in the heat conductive sheet is preferably 0.03 mass% or more and more preferably 0.04 mass% or more, and is preferably 5 mass% or less, more preferably 1 mass% or less, and further preferably 0.06 mass% or less, with respect to 100 mass% of the whole composition of the heat conductive sheet. If the content proportion of the fibrous carbon material in the heat conductive sheet is not less than the foregoing lower limit, the heat conductivity and strength of the heat conductive sheet can be improved sufficiently, and dusting of the particulate carbon material can be prevented sufficiently. If the content proportion of the fibrous carbon material in the heat conductive sheet is not more than the foregoing upper limit, a significant decrease in the flexibility of the heat conductive sheet caused by blending the fibrous carbon material can be suppressed, so that sufficiently high levels of heat conductivity and flexibility of the heat conductive sheet can both be achieved.

[[Additives]]

The heat conductive sheet can be optionally blended with additives known in the art that may be used for forming heat conductive sheets. Any additive may be blended into the heat conductive sheet. Examples of additives include plasticizers such as fatty acid esters, e.g. sebacic acid ester; flame retardants such as phosphorus red-based flame retardants and phosphate-based flame retardants; additives serving as both plasticizers and flame retardants such as fluorine oil (DEMNUM Series produced by Daikin Industries, Ltd.); toughness improvers such as urethane acrylates; moisture absorbents such as calcium oxide and magnesium oxide; adhesion improvers such as silane coupling agents, titanium coupling agents, and acid anhydrides; wettability improvers such as nonionic surfactants and fluorine surfactants; and ion trapping agents such as inorganic ion exchangers.

[Method of producing heat conductive sheet]

The heat conductive sheet can be produced, for example, by pressing a composition containing components such as the above-described resin and carbon material to form it into sheet shape, without being limited thereto. For example, the heat conductive sheet may be (A) a heat conductive sheet formed of one sheet-shaped product obtained as a result of the pressing or (B) a heat conductive sheet formed of a sliced piece obtained by slicing, approximately in the stacking direction, a laminate of a plurality of pre-heat conductive sheets which are each a sheet-shaped product obtained as a result of the pressing. Of these, the heat conductive sheet (B) is preferable in terms of exerting high heat conductivity in the thickness direction. A non-limiting example of the method of producing the heat conductive sheet (B) will be described below.

First, components such as the above-described thermoplastic resin that is solid at normal temperature and normal pressure, thermoplastic resin that is liquid at normal temperature and normal pressure, particulate carbon material, and fibrous carbon material are mixed under given conditions using a known mixing device such as a kneader, a roll, a Henschel mixer, or a Hobart mixer, to produce a heat conductive sheet composition.

The heat conductive sheet composition is then formed into sheet shape using a known forming method such as pressing, rolling or extruding, to form a pre-heat conductive sheet. It is presumed that, in the formed pre-heat conductive sheet, the carbon materials are aligned mainly in the in-plane direction, which contributes to improved heat conductivity of the pre-heat conductive sheet particularly in the in-plane direction.

A laminate is then formed by stacking a plurality of pre-heat conductive sheets obtained as described above in the thickness direction by any method or by folding or rolling a pre-heat conductive sheet. It is presumed that, in the formed laminate, the carbon materials are aligned mainly in a direction approximately orthogonal to the stacking direction.

The obtained laminate is sliced approximately in the stacking direction, i.e. sliced at an angle of 45° or less relative to the stacking direction, using a known method such as multi-blade method, laser processing method, water jet method, or knife processing method, to provide a heat conductive sheet formed of a sliced piece of the laminate. In terms of enhancing the heat conductivity of the heat conductive sheet, the angle at which the laminate is sliced is preferably 30° or less relative to the stacking direction, more preferably 15° or less relative to the stacking direction, and preferably approximately 0° relative to the stacking direction (i.e. along the stacking direction).

It is presumed that, in the formed heat conductive sheet, the carbon materials are aligned in the thickness direction. This suggests that the a heat conductive sheet yielded by the above-described method has high heat conductivity in the thickness direction and excellent electrical conductivity in the thickness direction.

<Structure of heat radiation device>

The presently disclosed heat radiation device is not limited as long as it has a structure in which the above-described heat conductive sheet having predetermined heat conductivity is sandwiched between the above-described heat generator and heat radiator under a predetermined area condition described in detail below. Any method may be used to sandwich the heat conductive sheet between the heat generator and the heat radiator, as long as the heat conductive sheet can be sandwiched with the heat generator being located on one side of the heat conductive sheet in the thickness direction and the heat radiator being located on the other side of the heat conductive sheet in the thickness direction.

[Sandwiched surface]

The sandwiched surface of the heat conductive sheet is a surface that is in contact with the heat generator or the heat radiator and is typically a surface orthogonal to the thickness direction of the heat conductive sheet. In the presently disclosed heat radiation device, the area of the sandwiched surface of the heat conductive sheet needs to be smaller than the area of the attached surface of the heat generator and the heat radiator.

As mentioned above, the heat conductivity of air is typically much lower than the heat conductivity of a heat conductive sheet. Accordingly, it is considered that, in normal cases, the heat resistance between the heat generator and the heat radiator can be reduced more when the amount of air between the facing heat generator and heat radiator is reduced more. Thus, it is commonly considered that the heat resistance between the heat generator and the heat radiator can be reduced by attaching, in a sandwiched manner, the heat conductive sheet to the whole attached surfaces of the heat generator and the heat radiator. In the presently disclosed heat radiation device, however, the heat resistance between the heat generator and the heat radiator can be reduced by sandwiching the heat conductive sheet in a state in which the area of the sandwiched surface of the heat conductive sheet having predetermined heat conductivity is smaller than the area of the attached surface of the heat generator and the heat radiator. In other words, in the presently disclosed heat radiation device, the use of a heat conductive sheet smaller in size than conventional heat conductive sheets can enhance the heat radiation of the heat radiation device efficiently.

The proportion of the area of the sandwiched surface of the heat conductive sheet to the area of the attached surface of the heat generator and the heat radiator is preferably 10 % or more and more preferably 20 % or more, and is preferably 70 % or less, more preferably 60 % or less, further preferably 50 % or less, and still more preferably 40 % or less. If the area proportion of the attached surface of the heat generator and the heat radiator and the sandwiched surface of the heat conductive sheet is not more than the foregoing upper limit, the heat resistance between the heat generator and the heat radiator can be decreased further efficiently, and the heat radiation of the heat radiation device can be enhanced more efficiently. If the area proportion of the attached surface of the heat generator and the heat radiator and the sandwiched surface of the heat conductive sheet is not less than the foregoing lower limit, high heat radiation of the heat radiation device can be maintained without excessively reducing the area of the heat conductive sheet in contact with the heat generator and the heat radiator.

When sandwiching the heat conductive sheet, it is preferable to directly attach the heat conductive sheet to a site of the heat generator that reaches the highest temperature in terms of more efficiently utilizing the heat conductivity of the heat conductive sheet, without being limited thereto. For example, in the case of using a power module including an insulated-gate bipolar transistor (IGBT) as a heat generator, it is preferable to attach the heat conductive sheet to an approximate center part of the surface of the heat generator facing the heat radiator, because the IGBT as a heat source is usually located in an approximate center part of the power module. Typically, the region where the heat conductive sheet is attached is preferably a region including the center point of the attached surface of the heat generator. The center point of the attached surface of the heat generator can be set according to the setting method for the center point on the measured surface in the above-described measurement of "surface irregularity".

[Sandwiching method]

The method of sandwiching the heat conductive sheet between the heat generator and the heat radiator is not limited as long as the above-described heat conductive sheet having predetermined heat conductivity is interposed between the heat generator and the heat radiator and the respective surfaces are attached in the above-described predetermined area relationship.

As the heat conductive sheet sandwiching method, for example, a method of fixing in a state in which each of the heat generator and the heat radiator and the heat conductive sheet interposed between the heat generator and the heat radiator are sufficiently in close contact with each other is preferable, even in the case where the surfaces of the heat generator and the heat radiator are strained. In terms of maintaining such favorable close adherence and easing operation, preferred examples of the heat conductive sheet sandwiching method include sandwiching methods with which the pressing force is maintained, such as screw clamping via a spring or sandwiching with a clip; and methods of sandwiching while pressing with any pressure. The pressure during the pressing is typically 0.05 MPa to 1.5 MPa, and preferably 0.1 MPa to 1.0 MPa.

EXAMPLES

The following provides a more specific description of the present disclosure based on examples. However, the present disclosure is not limited to the following examples. In the following description, "%" and "parts" used in expressing quantities are by mass, unless otherwise specified.

The surface irregularity and the surface irregularity shape of the heat generator, the heat conductivity and the Asker C hardness of the heat conductive sheet, and the heat resistance value of the heat radiation device in each of Examples and Comparative Examples were measured by the following methods.

<Surface irregularity and surface irregularity shape>

The surface irregularity of each of the heat generator and the heat radiator was measured using a three-dimensional shape measuring machine (produced by KEYENCE, product name "VR-3100 One-shot 3D Shape Measuring Machine"). The measured surfaces were the whole facing surface of the heat generator facing the heat radiator (i.e. the whole surface on the side on which the heat conductive sheet is attached) and the whole facing surface of the heat radiator facing the heat generator. Each measured surface was approximately rectangular. Assuming the short-side direction of the measured surface as X axis, the long-side direction of the measured surface as Y axis, the direction (thickness direction) orthogonal to the X axis and the Y axis as Z axis, and the point at which the diagonal lines intersect as the center point, the range of 10 mm × 10 mm in the X-axis direction and the Y-axis direction centered at the center point was set as a reference plane (measurement range). Next, the whole measured surface was measured using the three-dimensional shape measuring machine. A graph representing the surface irregularity shape state for the Z-axis direction on a line (parallel Y line) passing through a point (center X point) 0.6 mm away from the center point in the X-axis direction and parallel to the Y axis in the measured surface was then obtained. The parallel Y line passed through the highest point and the lowest point in the thickness direction in the plane of the measured surface. That is, a graph representing the section state of the measured surface with the horizontal axis as the parallel Y line and the vertical axis as the Z axis was obtained.

The absolute value of the height difference between the height of the reference plane and the maximum height (maximum value) and the absolute value of the height difference between the height of the reference plane and the minimum height (minimum value) in the Z-axis direction (thickness direction) in the obtained graph were calculated, and the larger absolute value was taken to be "surface irregularity" ($\mu$m).

The surface irregularity shape of the heat generator was determined as follows. The surface irregularity shape was determined based on the height relationship in the Z-axis direction between the center X point and both ends of the parallel Y line (both ends of the measurement range) in the graph obtained as described above. Specifically, the shape was determined as convexity in the case where the height of the center X point in the Z-axis direction was more than the height of each end of the parallel Y line in the Z-axis direction, and determined as concavity in the case where the height of the center X point in the Z-axis direction was less than the height of each end of the parallel Y line in the Z-axis direction. The shape was determined as having no irregularity in the case where the height of the center X point in the Z-axis direction was between the height of one end of the parallel Y line in the Z-axis direction and the height of the other end of the parallel Y line in the Z-axis direction.

<Heat conductivity>

The heat conductivity of the heat conductive sheet was measured using a resin material heat resistance tester (produced by Hitachi Technologies and Services, Ltd., product name "C47108"). Specifically, the heat conductive sheet was cut out to 1 cm $\times$ 1 cm as a sample, and the heat resistance value was measured at a pressure of 0.5 MPa and a sample temperature of 50 °C. Heat conductivity $\lambda$ (W/m·K) resulting from automatic conversion from the measured heat resistance value was then obtained.

Higher heat conductivity indicates better heat conductivity of the heat conductive sheet and better heat radiation of the heat radiation device formed by interposing the heat conductive sheet between the heat generator and the heat radiator.

<Asker C hardness>

The Asker C hardness of the heat conductive sheet was measured at 25 °C using a hardness meter in accordance with the Asker C method of the Society of Rubber Industry, Japan Standard (SRIS0101).

Specifically, the original piece of the obtained heat conductive sheet was cut out to a size of 25 mm in length, 50 mm in width, and 0.3 mm in thickness in Examples 1 to 4, Example 6, Comparative Examples 1 to 4, and Comparative Example 6, to a size of 25 mm in length, 50 mm in width, and 1.3 mm in thickness in Example 5 and Comparative Example 5, and to a size of 25 mm in length, 50 mm in width, and 0.5 mm in thickness in Comparative Examples 7 to 12. 50 pieces were then stacked each to obtain a test piece. The obtained test piece was placed for at least 48 hours in a thermostatic chamber maintained at 25 °C to prepare a specimen. The damper height was adjusted so that the indicator pointed at 95 to 98, and the specimen and the damper were collided with each other. The Asker C hardness of the specimen after 60 sec from the collision was measured 2 times using a hardness meter (produced by KOBUNSHI KEIKI Co., Ltd., product name "ASKER CL-150LJ"), and an average of measured values was taken to be the Asker C hardness. Typically, lower Asker C hardness indicates higher flexibility.

<Heat resistance>

The heat resistance value of the heat radiation device was measured as follows, using a transient heat measurement device (produced by Mentor Graphics, product name "T3Ster") and a pressing jig (produced by KeenusDesign Corp.) for the produced heat radiation device. An IGBT-equipped power module was used as the heat generator, and a heat sink (produced by KeenusDesign Corp.) cooled with a Peltier device was used as the heat radiator.

For the obtained heat radiation device, the initial temperature of the heat radiator was set to 25 °C. Current was then applied to the heat generator in the heat radiation device under the conditions of heating current: 10 A and heating time: 150 sec, to heat the heat generator. While heating the heat generator, a pressure of 0.50 MPa was applied to the heat conductive sheet sandwiched between the heat generator and the heat radiator. Subsequently, current was applied between the heated heat generator and the heat radiator under the conditions of measurement current: 20 mA and measurement time: 150 sec, and the temperature T1 (°C) of the heated heat generator and the temperature T2 (°C) of the heat radiator were measured. Using the obtained T1 and T2 and the power W (W) applied to the heat generator, the value X (°C/W) of the heat resistance between the heat generator and the heat radiator via the heat conductive sheet in the heat radiation device was calculated according to the following expression (I):

$$X = (T1 - T2)/W \qquad \dots (I).$$

A lower heat resistance value indicates higher heat transfer from the heat generator to the heat radiator and higher radiation.

Herein, the decreased value of heat resistance (heat resistance decrease amount) resulting from setting the area of the sandwiched surface of the heat conductive sheet to be smaller than the area of the attached surface can be calculated using the heat resistance value X1 in the case where the area of the sandwiched surface of the heat conductive sheet was smaller than the area of the attached surface and the heat resistance value X2 in the case where the area of the sandwiched surface of the heat conductive sheet was equal to the area of the attached surface, according to the following expression (II):

$$\text{heat resistance decrease amount} = (X2 - X1) \quad ... \text{(II)}.$$

Herein, a plus heat resistance decrease amount (°C/W) indicates that the heat resistance value decreased, and a minus heat resistance decrease amount (°C/W) indicates that the heat resistance value increased.

Herein, the proportion of the deceased heat resistance (heat resistance decrease proportion) resulting from setting the area of the sandwiched surface of the heat conductive sheet to be smaller than the area of the attached surface can be calculated using X1 and X2, according to the following expression (III):

$$\text{heat resistance decrease proportion} = (X1/X2) \times 100 \quad ... \text{(III)}.$$

A heat resistance decrease proportion (%) of less than 100 % indicates that the heat resistance value decreased, and a heat resistance decrease proportion (%) of more than 100 % indicates that the heat resistance value increased.

(Example 1)

<Production of fibrous carbon nanostructures including CNTs>

Fibrous carbon nanostructures including SGCNTs were obtained by a super growth method in accordance with the contents of WO2006/011655.

The obtained fibrous carbon nanostructures had a G/D ratio of 3.0, a BET specific surface area of 800 $m^2/g$, and a mass density of 0.03 $g/cm^3$. As a result of measuring the diameters of randomly-selected 100 fibrous carbon nanostructures using a transmission electron microscope, the average diameter (Av) was 3.3 nm, the value ($3\sigma$) obtained by multiplying the sample standard deviation ($\sigma$) of diameters by 3 was 1.9 nm, their ratio ($3\sigma/Av$) was 0.58, and the average length was 100 $\mu$m. The obtained fibrous carbon nanostructures were mainly composed of single-walled CNTs (hereafter also referred to as "SWCNTs").

<Production of easily dispersible aggregate of fibrous carbon nanostructures>

[Production of dispersion liquid]

400 mg of the obtained fibrous carbon nanostructures as a fibrous carbon material were weighed, and mixed into 2 L of methyl ethyl ketone as a solvent. The mixture was stirred for 2 min by a homogenizer, to obtain a coarse dispersion liquid. The obtained coarse dispersion liquid was then passed through a flow path of 0.5 mm of a wet-type jet mill at a pressure of 100 MPa for 2 cycles using a wet-type jet mill (produced by JOKOH Co., Ltd., product name "JN-20"), to disperse the fibrous carbon nanostructures in the methyl ethyl ketone. A dispersion liquid with a solid content concentration of 0.20 mass% was thus obtained.

[Removal of solvent]

The obtained dispersion liquid was then filtrated under reduced pressure using Kiriyama Filter Paper (No. 5A), to obtain a sheet-shaped easily dispersible aggregate.

<Production of heat conductive sheet composition>

0.1 parts by mass of the obtained easily dispersible aggregate of fibrous carbon nanostructures as a fibrous carbon material, 85 parts by mass of expanded graphite (produced by Ito Graphite Co., Ltd., product name "EC-50", average particle diameter: 250 $\mu$m) as a particulate carbon material, 40 parts by mass of thermoplastic fluororesin that is solid at normal temperature (produced by Daikin Industries, Ltd., product name "DAI-EL G-704BP") and 45 parts by mass of thermoplastic fluororesin that is liquid at normal temperature (produced by Daikin Industries, Ltd., product name "DAI-EL G-101") as resins, and 5 parts by mass of sebacic acid ester (produced by Daihachi Chemical Industry Co., Ltd., product name "DOS") as a plasticizer were mixed under stirring for 5 min in the presence of 100 parts of ethyl acetate as a solvent using a Hobart mixer (produced by Kodaira Seisakusho Co., Ltd., product name "Model ACM-5LVT"). The resulting mixture was then defoamed under vacuum for 30 min, removing ethyl acetate simultaneously with defoaming to afford a heat conductive sheet composition containing thermoplastic fluororesin that is solid at normal temperature, thermoplastic fluororesin that is liquid at normal temperature, expanded graphite, and fibrous carbon nanostructures (SGCNTs). The resulting composition was charged into a crusher and crushed for 10 sec.

<Formation of pre-heat conductive sheet>

Next, 5 g of the crush composition was sandwiched between 50 $\mu$m-thick sandblasted PET films (protective films) and rolled under the following conditions: roll-to-roll gap = 550 $\mu$m, roll temperature = 50 °C, roll linear pressure = 50 kg/cm, roll speed = 1 m/min, to afford a pre-heat conductive sheet having a thickness of 0.5 mm.

<Formation of laminate>

The resultant pre-heat conductive sheet was cut to 60 mm in length, 60 mm in width, and 0.5 mm in thickness. 120 pre-heat conductive sheets were then stacked on top of each other in the pre-heat conductive sheet thickness direction with double sided tape, to afford a laminate having a thickness of about 60 mm.

<Production of heat conductive sheet>

The laminate of pre-heat conductive sheets was then sliced at an angle of 0° relative to the stacking direction (in other words, sliced in a direction normal to the main surface of the stacked pre-heat conductive sheets) using a slicer for woodworking (produced by Marunaka Tekkosho Inc., product name "Super Surfacer SUPER MECA S") while pressing a lamination section of the laminate at a pressure of 0.3 MPa, to afford an original piece of a heat conductive sheet of 60 mm in length, 60 mm in width, and 0.3 mm in thickness. Further, the size of the resultant original piece was adjusted to 15 mm in length, 15 mm in width, and 0.3 mm in thickness, to afford a heat conductive sheet.
The sandwiched surface of the resultant heat conductive sheet was a quadrilateral with an outer diameter of 15 mm in length and 15 mm in width, and had an area of 225 mm$^2$.
The slicer for woodworking was a double-edged slicer in which two single edges were in contact on the opposite sides of a cutting edge, the tip of the edge of a front blade was 0.5 mm higher than the tip of the edge of a back blade with the protrusion length of the blade from the slit being 0.11 mm, and the blade angle of the front blade was 21°.
The heat conductivity and Asker C hardness of the obtained heat conductive sheet were measured according to the foregoing measurement methods. The results are shown in Table 1.

<Production of heat radiation device>

An IGBT-equipped power module (produced by STMicroelectronic device, model number "STGE200NB60S", surface irregularity: 30 $\mu$m, surface irregularity shape: concavity) was prepared as a heat generator. The surface irregularity and surface irregularity shape of the heat generator were measured and determined according to the foregoing measurement methods. The results are shown in Table 1.
An aluminum heat sink (produced by KeenusDesign Corp., product name "PDS-100", Peltier device cooling, surface irregularity: 5 $\mu$m or less) was prepared as a heat radiator.
The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm$^2$. The area of the attached surface of the heat generator and the heat radiator was 950 mm$^2$.
The obtained heat conductive sheet was bonded onto the heat generator so that an approximate center part of the surface of the heat generator on the side facing the heat radiator and an approximate center part of the heat conductive sheet overlapped each other. Moreover, the surface of the bonded heat conductive sheet not in contact with the heat generator and the heat radiator were brought into contact with each other so that their approximate center parts overlapped each other. Further, the heat generator and the heat radiator facing each other via the heat conductive sheet were pressed using a pressing device (produced by KeenusDesign Corp., product name "PDPT-50-250N") so as to apply a force of 0.5 MPa to the heat conductive sheet.
The heat resistance value of the produced heat radiation device was measured according to the foregoing measurement method. The results are shown in Table 1.

(Example 2)

A heat conductive sheet composition, a pre-heat conductive sheet, a heat conductive sheet, and a heat radiation device were produced in the same way as Example 1 except that the type of the heat generator was changed to a different type of IGBT-equipped power module (produced by Vishay Co., model number "VS-GA200SA60UP", surface irregularity: 10 μm, surface irregularity shape: concavity) from Example 1 in the production of the heat radiation device. The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm$^2$. The area of the attached surface of the heat generator and the heat radiator was 950 mm$^2$.
The measurements were performed in the same way as Example 1. The results are shown in Table 1.

(Example 3)

A heat conductive sheet composition, a pre-heat conductive sheet, a heat conductive sheet, and a heat radiation device were produced in the same way as Example 1 except that the type of the heat generator was changed to a different type of IGBT-equipped power module (produced by IXYS Corporation, model number "IXYN80N90C3H1", surface irregularity: 40 μm, surface irregularity shape: convexity) from Example 1 in the production of the heat radiation device. The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm$^2$. The area of the attached surface of the heat generator and the heat radiator was 950 mm$^2$.
The measurements were performed in the same way as Example 1. The results are shown in Table 1.

(Example 4)

A heat conductive sheet composition, a pre-heat conductive sheet, a heat conductive sheet, and a heat radiation device were produced in the same way as Example 1 except that the composition was produced as follows in the production of the heat conductive sheet composition, and the type of the heat generator was changed to a different type of IGBT-equipped power module (produced by Vishay Co., model number "VS-GA200SA60UP", surface irregularity: 10 μm, surface irregularity shape: concavity) from Example 1 in the production of the heat radiation device. The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm$^2$. The area of the attached surface of the heat generator and the heat radiator was 950 mm$^2$.
The measurements were performed in the same way as Example 1. The results are shown in Table 1.

<Production of heat conductive sheet composition>

0.1 parts by mass of the easily dispersible aggregate of fibrous carbon nanostructures as a fibrous carbon material, 50 parts by mass of expanded graphite (produced by Ito Graphite Co., Ltd., product name "EC-100", average particle diameter: 190 μm) as a particulate carbon material, and 100 parts by mass of thermoplastic fluororesin that is liquid at normal temperature (produced by Daikin Industries, Ltd., product name "DAI-EL G-101") as a resin were charged into a Hobart mixer (produced by Kodaira Seisakusho Co., Ltd., product name "Model ACM-5LVT"), heated to a temperature of 80 °C and held at the temperature, and mixed under stirring for 30 min. As a result of the mixture, a heat conductive sheet composition containing thermoplastic fluororesin that is liquid at normal temperature, expanded graphite, and fibrous carbon nanostructures (SGCNTs) was obtained. The resulting composition was charged into a Wonder Crush Mill (produced by OSAKA CHEMICAL Co., Ltd., product name "D3V-10") and crushed for 1 min.

(Example 5)

A heat conductive sheet composition, a pre-heat conductive sheet, a heat conductive sheet, and a heat radiation device were produced in the same way as Example 4 except that, in the production of the heat conductive sheet, the laminate was sliced to a size of 60 mm in length, 60 mm in width, and 1.3 mm in thickness to obtain an original piece of a heat conductive sheet, and the size of the original piece was adjusted to 15 mm in length, 15 mm in width, and 1.3 mm in thickness to obtain the heat conductive sheet. The sandwiched surface of the heat conductive sheet obtained in this way was a quadrilateral with an outer diameter of 15 mm in length and 15 mm in width, and had an area of 225 mm$^2$.
The measurements were performed in the same way as Example 1. The results are shown in Table 1.

(Example 6)

A heat conductive sheet composition, a pre-heat conductive sheet, a heat conductive sheet, and a heat radiation device were produced in the same way as Example 1 except that, in the production of the heat conductive sheet, the size of the original piece was adjusted to 25 mm in length, 25 mm in width, and 0.3 mm in thickness to obtain the heat conductive sheet. The sandwiched surface of the heat conductive sheet obtained in this way was a quadrilateral with an outer diameter of 25 mm in length and 25 mm in width, and had an area of 625 mm$^2$.
The measurements were performed in the same way as Example 1. The results are shown in Table 1.

(Comparative Examples 1 to 4)

Comparative Examples 1 to 4 are mainly for comparison of the heat resistance of the heat radiation device respectively with Examples 1 to 4.
A heat conductive sheet composition, a pre-heat conductive sheet, a heat conductive sheet, and a heat radiation device were produced in the same way as Examples 1 to 4 except the following: In the production of the heat conductive sheet, the size of the original piece was adjusted to 38 mm in length, 25 mm in width, and 0.3 mm in thickness to obtain the heat conductive sheet. The sandwiched surface of the heat conductive sheet obtained in this way was a quadrilateral with an outer diameter of 38 mm in length and 25 mm in width, and had an area of 950 mm$^2$. Moreover, in the production of the heat radiation device, the heat conductive sheet was bonded onto the heat generator so as to cover the whole surface of the heat generator on the side facing the heat radiator.
The measurements were performed in the same way as Example 1. The results are shown in Table 1.

(Comparative Example 5)

Comparative Example 5 is mainly for comparison of the heat resistance of the heat radiation device with Example 5.
A heat conductive sheet composition, a pre-heat conductive sheet, a heat conductive sheet, and a heat radiation device were produced in the same way as Example 5 except the following: In the production of the heat conductive sheet, the size of the original piece was adjusted to 38 mm in length, 25 mm in width, and 1.3 mm in thickness to obtain the heat conductive sheet. The sandwiched surface of the heat conductive sheet obtained in this way was a quadrilateral with an outer diameter of 38 mm in length and 25 mm in width, and had an area of 950 mm$^2$. Moreover, in the production of the heat radiation device, the heat conductive sheet was bonded onto the heat generator so as to cover the whole surface of the heat generator on the side facing the heat radiator.
The measurements were performed in the same way as Example 1. The results are shown in Table 1.

(Comparative Example 6)

Comparative Example 6 is mainly for comparison of the heat resistance of the heat radiation device with Example 6.
A heat conductive sheet composition, a pre-heat conductive sheet, a heat conductive sheet, and a heat radiation device were produced in the same way as Example 6 except the following: In the production of the heat conductive sheet, the size of the original piece was adjusted to 38 mm in length, 25 mm in width, and 0.3 mm in thickness to obtain the heat conductive sheet. The sandwiched surface of the heat conductive sheet obtained in this way was a quadrilateral with an outer diameter of 38 mm in length and 25 mm in width, and had an area of 950 mm$^2$. Moreover, in the production of the heat radiation device, the heat conductive sheet was bonded onto the heat generator so as to cover the whole surface of the heat generator on the side facing the heat radiator.
The measurements were performed in the same way as Example 1. The results are shown in Table 1.

(Comparative Example 7)

A heat radiation device was produced in the same way as Example 1 except that, without producing a heat conductive sheet, a commercially available heat conductive sheet (produced by Denka Company Limited, model number "FSL-050B", outer diameter: adjusted to 15 mm in length, 15 mm in width, and 0.5 mm in thickness) was used instead of the heat conductive sheet produced by the method described in Example 1. The sandwiched surface of the heat conductive sheet obtained in this way was a quadrilateral with an outer diameter of 15 mm in length and 15 mm in width, and had an area of 225 mm$^2$.
The measurements were performed in the same way as Example 1. The results are shown in Table 1.

(Comparative Example 8)

A heat radiation device was produced in the same way as Example 1 except the following: Without producing a heat conductive sheet, a commercially available heat conductive sheet (produced by Denka Company Limited, model number "FSL-050B", outer diameter: adjusted to 15 mm in length, 15 mm in width, and 0.5 mm in thickness) was used instead of the heat conductive sheet produced by the method described in Example 1. The sandwiched surface of the heat conductive sheet obtained in this way was a quadrilateral with an outer diameter of 15 mm in length and 15 mm in width, and had an area of 225 mm$^2$. Moreover, the type of the heat generator was changed to a different type of IGBT-equipped power module (produced by Vishay Co., model number "VS-GA200SA60UP", surface irregularity: 10 $\mu$m, surface irregularity shape: concavity) from Example 1 in the production of the heat radiation device. The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm$^2$. The area of the attached surface of the heat generator and the heat radiator was 950 mm$^2$.

The measurements were performed in the same way as Example 1. The results are shown in Table 1.

(Comparative Example 9)

A heat radiation device was produced in the same way as Example 1 except the following: Without producing a heat conductive sheet, a commercially available heat conductive sheet (produced by Denka Company Limited, model number "FSL-050B", outer diameter: adjusted to 15 mm in length, 15 mm in width, and 0.5 mm in thickness) was used instead of the heat conductive sheet produced by the method described in Example 1. The sandwiched surface of the heat conductive sheet obtained in this way was a quadrilateral with an outer diameter of 15 mm in length and 15 mm in width, and had an area of 225 mm$^2$. Moreover, the type of the heat generator was changed to a different type of IGBT-equipped power module (produced by IXYS Corporation, model number "IXYN80N90C3H1", surface irregularity: 40 $\mu$m, surface irregularity shape: convexity) from Example 1 in the production of the heat radiation device. The whole facing surface of the prepared heat generator was a quadrilateral with an outer diameter of 38 mm in length and 25 mm in width, and had an area of 950 mm$^2$. The whole facing surface of the prepared heat radiator was a quadrilateral with an outer diameter of 50 mm in length and 50 mm in width, and had an area of 2500 mm2. The area of the attached surface of the heat generator and the heat radiator was 950 mm$^2$.

The measurements were performed in the same way as Example 1. The results are shown in Table 1.

(Comparative Examples 10 to 12)

Comparative Examples 10 to 12 are mainly for comparison of the heat resistance of the heat radiation device respectively with Comparative Examples 7 to 9.

A heat radiation device was produced in the same way as Comparative Examples 7 to 9 except the following: Without producing a heat conductive sheet, the size of a commercially available heat conductive sheet was adjusted to 38 mm in length, 25 mm in width, and 0.5 mm in thickness for use as the heat conductive sheet. The sandwiched surface of the heat conductive sheet obtained in this way was a quadrilateral with an outer diameter of 38 mm in length and 25 mm in width, and had an area of 950 mm$^2$. Moreover, in the production of the heat radiation device, the heat conductive sheet was bonded onto the heat generator so as to cover the whole surface of the heat generator on the side facing the heat radiator.

The measurements were performed in the same way as Example 1. The results are shown in Table 1.

[Table 1]

| | | | | Example 1 | Example 2 | Example 3 | Example 4 | Example 5 | Example 6 | Comparative Example 7 | Comparative Example 8 | Comparative Example 9 |
|---|---|---|---|---|---|---|---|---|---|---|---|---|
| | Heat generator | | Surface irregularity shape | Concavity | Concavity | Concavity | Concavity | Concavity | Concavity | Concavity | Concavity | Convexity |
| | | | Surface irregularity [μm] | 30 | 10 | 40 | 10 | 10 | 30 | 30 | 10 | 40 |
| | | | Area of whole facing surface (outer diameter: 38mm x 25mm) [mm²] | 950 | 950 | 950 | 950 | 950 | 950 | 950 | 950 | 950 |
| | Heat radiator | | Surface irregularity [μm] | 5 or less | 5 or less | 5 or less | 5 or less | 5 or less | 5 or less | 5 or less | 5 or less | 5 or less |
| | | | Area of whole facing surface (outer diameter: 50mm x 50mm) [mm²] | 2500 | 2500 | 2500 | 2500 | 2500 | 2500 | 2500 | 2500 | 2500 |
| Heat radiation device | Area of attached surface of heat generator and heat radiator [mm²] | | | 950 | 950 | 950 | 950 | 950 | 950 | 950 | 950 | 950 |
| | Heat conductive sheet | Composition [parts by mass] | Resin — Thermoplastic resin solid at normal temperature and normal pressure | 40 | 40 | 40 | - | - | 40 | Commercial product | Commercial product | Commercial product |
| | | | Resin — Thermoplastic resin liquid at normal temperature and normal pressure | 45 | 45 | 45 | 100 | 100 | 45 | | | |
| | | | Plasticizer — Sebacic acid ester | 5 | 5 | 5 | - | - | 5 | | | |
| | | | Carbon material — Particulate carbon material (average particle diameter: 250μm) | 85 | 85 | 85 | - | - | 85 | | | |
| | | | Carbon material — Particulate carbon material (average particle diameter: 100μm) | - | - | - | 50 | 50 | - | | | |
| | | | Fibrous carbon material | 0.1 | 0.1 | 0.1 | 0.1 | 0.1 | 0.1 | | | |
| | | Properties | Sheet heat conductivity (temperature: 50°C, pressure: 0.5MPa) λ [W/m·K] | 30 | 30 | 30 | 15 | 15 | 30 | 4 | 4 | 4 |
| | | | Asker C hardness [-] | 68 | 68 | 68 | 45 | 45 | 68 | 25 | 25 | 25 |
| | | | Thickness [mm] | 0.3 | 0.3 | 0.3 | 0.3 | 1.3 | 0.3 | 0.5 | 0.5 | 0.5 |
| | | | Area of sandwiched surface (outer diameter: 15mm x 15mm) [mm²] | 225 | 225 | 225 | 225 | 225 | - | 225 | 225 | 225 |
| | | | Area of sandwiched surface (outer diameter: 25mm x 25mm) [mm²] | - | - | - | - | - | 625 | - | - | - |
| | Area of sandwiched surface/area of attached surface of heat generator and heat radiator [%] | | | 23.7 | 23.7 | 23.7 | 23.7 | 23.7 | 65.8 | 23.7 | 23.7 | 23.7 |
| Evaluation item 1 | Heat resistance X1 between heat generator and heat radiator [°C/W] | | | 0.405 | 0.518 | 0.607 | 0.392 | 0.456 | 0.491 | 0.968 | 0.991 | 1.103 |

| | | | Comparative Example 1 | Comparative Example 2 | Comparative Example 3 | Comparative Example 4 | Comparative Example 5 | Comparative Example 6 | Comparative Example 10 | Comparative Example 11 | Comparative Example 12 |
|---|---|---|---|---|---|---|---|---|---|---|---|
| Heat radiation device | Heat generator | | Same as Example 1 | Same as Example 2 | Same as Example 3 | Same as Example 4 | Same as Example 5 | Same as Example 6 | Same as Comparative Example 7 | Same as Comparative Example 8 | Same as Comparative Example 9 |
| | Heat radiator | | | | | | | | | | |
| | Heat conductive sheet | Composition and properties (except area of sandwiched surface) | | | | | | | | | |
| | | Area of sandwiched surface (outer diameter: 38mm x 25mm) [mm²] | 950 | 950 | 950 | 950 | 950 | 950 | 950 | 950 | 950 |
| | Area of sandwiched surface/area of attached surface of heat generator and heat radiator [%] | | 100.0 | 100.0 | 100.0 | 100.0 | 100.0 | 100.0 | 100.0 | 100.0 | 100.0 |
| Evaluation item 2 | Heat resistance X2 between heat generator and heat radiator [°C/W] | | 0.669 | 0.682 | 0.639 | 0.518 | 0.591 | 0.669 | 0.629 | 0.681 | 0.829 |
| Evaluation item 3 | Heat resistance decrease amount (X2-X1) [°C/W] | | 0.264 | 0.164 | 0.032 | 0.126 | 0.135 | 0.178 | -0.339 | -0.310 | -0.274 |
| | Heat resistance decrease proportion (X1/X2 x 100) [%] | | 60.5 | 76.0 | 95.0 | 75.7 | 77.2 | 73.4 | 153.9 | 145.5 | 133.1 |

As can be understood from Table 1, in Examples 1 to 6 in which a heat conductive sheet having at least predetermined high heat conductivity was used and the area of the sandwiched surface of the heat conductive sheet was smaller than the area of the attached surface of the heat generator and the heat radiator, the heat resistance value was low and the heat radiation of the heat radiation device was high as compared with Comparative Examples 7 to 12 in which the heat conductivity of the heat conductive sheet was less than the predetermined heat conductivity.

Moreover, in Examples 1 to 6 in which a heat conductive sheet having at least predetermined high heat conductivity was used and the area of the sandwiched surface of the heat conductive sheet was smaller than the area of the attached surface of the heat generator and the heat radiator, the heat resistance value decreased and the heat radiation of the heat radiation device improved as compared with respectively Comparative Examples 1 to 6 in which the same heat conductive sheet was used and the area of the sandwiched surface of the heat conductive sheet was equal to the area of the attached surface, in all comparison patterns (e.g. comparison pattern of Example 1 and Comparative Example 1 to comparison pattern of Example 6 and Comparative Example 6).

Regarding Comparative Examples 7 to 12 in which the heat conductivity of the heat conductive sheet was less than the predetermined heat conductivity, in Comparative Examples 7 to 9 in which the area of the sandwiched surface of the heat conductive sheet was smaller than the area of the attached surface, the heat resistance value increased and the heat radiation of the heat radiation device deteriorated as compared with respectively Comparative Examples 10 to 12 in which the area of the sandwiched surface of the heat conductive sheet was equal to the area of the attached surface.

INDUSTRIAL APPLICABILITY

It is therefore possible to provide a heat radiation device that can achieve high heat radiation.

Claims

1. A heat radiation device comprising:

a heat generator;
a heat radiator; and
a heat conductive sheet attached in a sandwiched manner between the heat generator and the heat radiator, wherein the heat conductive sheet contains a resin and an expanded graphite, a heat conductivity of the heat conductive sheet in a thickness direction is 15 W/m·K or more, and an area of a sandwiched surface of the heat conductive sheet is smaller than an area of an attached surface of the heat generator and the heat radiator.

2. The heat radiation device according to claim 1, wherein an Asker C hardness of the heat conductive sheet at 25 °C is 30 or more.

3. The heat radiation device according to claim 1 or 2, wherein a thickness of the heat conductive sheet is 2.0 mm or less.

4. The heat radiation device according to any one of claims 1 to 3, wherein a proportion of the area of the sandwiched surface of the heat conductive sheet to the area of the attached surface of the heat generator and the heat radiator is 10 % or more and 70 % or less.

5. The heat radiation device according to any one of claims 1 to 4, wherein an attached surface of at least one of the heat generator and the heat radiator has a surface irregularity of more than 5 $\mu$m.

6. The heat radiation device according to any one of claims 1 to 5, wherein the resin is a thermoplastic resin.

**Patentansprüche**

1. Wärmestrahlungsvorrichtung umfassend

   einen Wärmeerzeuger;
   einen Wärmestrahler; und
   eine wärmeleitende Folie, die Sandwich-artig zwischen dem Wärmeerzeuger und dem Wärmestrahler angebracht ist,
   wobei die wärmeleitende Folie ein Harz und einen expandierten Graphit enthält, die Wärmeleitfähigkeit der wärmeleitenden Folie in Richtung der Dicke 15 W/m · K oder mehr beträgt und
   eine Fläche einer sandwichartigen Oberfläche der wärmeleitenden Folie kleiner ist als eine Fläche einer angebrachten Oberfläche des Wärmeerzeugers und des Wärmestrahlers.

2. Wärmestrahlungsvorrichtung nach Anspruch 1, wobei die Asker-C-Härte der wärmeleitenden Folie bei 25 °C 30 oder mehr beträgt.

3. Wärmestrahlungsvorrichtung nach Anspruch 1 oder 2, wobei die Dicke der wärmeleitenden Folie 2,0 mm oder weniger beträgt.

4. Wärmestrahlungsvorrichtung nach einem der Ansprüche 1 bis 3, wobei das Verhältnis der Fläche der sandwichartig angebrachten Oberfläche der wärmeleitenden Folie zur Fläche der befestigten Oberfläche des Wärmeerzeugers und des Wärmestrahlers 10 % oder mehr und 70 % oder weniger beträgt.

5. Wärmestrahlungsvorrichtung nach einem der Ansprüche 1 bis 4, wobei eine angebrachte Oberfläche des Wärmeerzeugers und/oder des Wärmestrahlers eine Oberflächenunregelmäßigkeit von mehr als 5 $\mu$m aufweist.

6. Die Wärmestrahlungsvorrichtung nach einem der Ansprüche 1 bis 5, wobei das Harz ein thermoplastisches Harz ist.

**Revendications**

1. Dispositif à rayonnement thermique comprenant :

   un générateur de chaleur ;
   un radiateur thermique ; et
   une feuille thermoconductrice fixée en sandwich entre le générateur de chaleur et le radiateur thermique,
   dans lequel la feuille thermoconductrice contient une résine et un graphite expansé, une conductivité thermique de la feuille thermoconductrice dans une direction de l'épaisseur étant de 15 W/m·K ou plus et
   une superficie d'une surface en sandwich de la feuille thermoconductrice est inférieure à une superficie d'une surface fixée du générateur de chaleur et du radiateur thermique.

**2.** Dispositif à rayonnement thermique selon la revendication 1, dans lequel une dureté Asker C de la feuille thermoconductrice à 25 °C est de 30 ou plus.

**3.** Dispositif à rayonnement thermique selon la revendication 1 ou 2, dans lequel une épaisseur de la feuille thermoconductrice est de 2,0 mm ou moins.

**4.** Dispositif à rayonnement thermique selon l'une des revendications 1 à 3, dans lequel une proportion de la superficie de la surface en sandwich de la feuille thermoconductrice par rapport à la superficie fixée du générateur de chaleur et du radiateur thermique est de 10 % ou plus et de 70 % ou moins.

**5.** Dispositif à rayonnement thermique selon l'une des revendications 1 à 4, dans lequel une surface fixée d'au moins un parmi le générateur de chaleur et le radiateur thermique présente une irrégularité de surface supérieure à 5 $\mu$m.

**6.** Dispositif à rayonnement thermique selon l'une des revendications 1 à 5, dans lequel la résine est une résine thermoplastique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008153430 A
- US 2015315451 A1
- EP 2546871 A1
- US 2012236502 A1
- JP 2010132856 B
- WO 2006011655 A